Europäisches Patentamt

European Patent Office

Office européen des brevets

(11) Veröffentlichungsnummer: **0 199 887**
**B1**

(12) # EUROPÄISCHE PATENTSCHRIFT

(45) Veröffentlichungstag der Patentschrift:
09.08.89

(21) Anmeldenummer: 86100393.7

(22) Anmeldetag: 14.01.86

(51) Int. Cl.⁴: **H 03 D 3/00, H 03 J 7/06**

(54) **FM-Funkempfänger.**

(30) Priorität: 02.05.85 DE 3515746

(43) Veröffentlichungstag der Anmeldung:
05.11.86 Patentblatt 86/45

(45) Bekanntmachung des Hinweises auf die Patenterteilung: 09.08.89 Patentblatt 89/32

(84) Benannte Vertragsstaaten:
AT BE CH DE FR GB IT LI LU NL SE

(56) Entgegenhaltungen:
DE—A— 3 231 708
GB—A— 2 079 552
US—A— 3 530 383
US—A— 4 355 414

(73) Patentinhaber: ROBERT BOSCH GMBH
Postfach 50
D-7000 Stuttgart 1 (DE)

(72) Erfinder: Katzy, Bernd-Michael, Dipl.-Ing.
Sakrower Landstrasse 101 N
D-1000 Berlin 22 (DE)

(74) Vertreter: Schmidt, Hans-Ekhardt
Robert Bosch GmbH Geschäftsbereich Elektronik
Patent- und Lizenzabteilung Forckenbeckstrasse 9-
13
D-1000 Berlin 33 (DE)

## Beschreibung

### Stand der Technik

Die Erfindung geht von einem FM-Funkempfänger nach der Gattung des Patentanspruchs 1 aus.

Es ist schon eine Filter- und Demodulationsschaltung für FM-Funkempfänger bekannt (DE-OS 32 31 708), deren Empfindlichkeit bei niedrigen Empfangsfeldstärken verbesserungswürdig ist. Unterschreitet nämlich die Empfangsfeldstärke einen bestimmten Wert, so wird das Nutzsignal durch das Empfängerrauschen überdeckt.

Es ist weiterhin ein Funkempfänger bekannt (GB-A-2 079 552), bei dem das NF-Signal von einer ersten PLL-Schleife abgeleitet wird. Von zwei weiteren PLL-Schleifen wird eine zweite nach dem Einrasten der ersten PLL-Schleife zur Umschaltung für die dritte PLL-Schleife benutzt, die zur Bandmittenabstimmung des ZF-Übertragungsweges dient.

### Vorteile der Erfindung

Der erfindungsgemäße FM-Funkempfänger mit den Merkmalen des Patentanspruchs 1 hat den Vorteil, daß der Rauschpegel bei kleinen Empfangsfeldstärken verringert wird, indem die Bandbreite bei der Selektion reduziert wird.

Durch die in den abhängigen Ansprüchen aufgeführten Maßnahmen sind vorteilhafte Weiterbildungen und Verbesserungen des in dem Patentanspruch 1 angegebenen FM-Funkempfängers möglich. Besonders vorteilhaft ist ein erfindungsgemäßer FM-Funkempfänger, bei dem zwischen dem Zwischenfrequenzbandfilter und der ersten PLL-Schleife ein Umschalter liegt, der in einer ersten Schaltstellung das Zwischenfrequenzbandfilter unmittelbar mit dem Zwischenfrequenzverstärker und in einer zweiten Schaltstellung das Zwischenfrequenzbandfilter über einen Verstärker, einen Schwellwertschalter und eine erste PLL-Schleife mit dem Zwischenfrequenzverstärker verbindet. Ein FM-Funkempfänger mit den vorgenannten Merkmalen hat den Vorteil, daß immer dann, wenn die jeweilige Empfangsfeldstärke verhältnismäßig gering ist, durch Betätigung eines Umschalters von Hand oder durch automatische Umschaltung in Abhängigkeit von dem Zwischenfrequenzsignalpegel eine erhebliche Steigerung der Empfindlichkeit erreicht wird. Damit wird gleichzeitig die Rauschbandbreite eingeschränkt und auch der Empfang bei Fremdstörungen verbessert. Die Erfindung kann im übrigen auch bei einem Empfänger für Phasenmodulation, das heißt einem PM-Empfänger, mit Vorteil angewendet werden.

### Zeichnung

Zwei Ausführungsbeispiele der Erfindung sind in der Zeichnung anhand zweier Figuren dargestellt und in der nachfolgenden Beschreibung näher erläutert. Die Zeichnung zeigt in

Fig. 1 ein Blockschaltbild eines ZF-Teils und eines Demodulators eines erfindungsgemäßen FM-Funkempfängers und

Fig. 2 ein Blockschaltbild einer Umschaltautomatik für einen erfindungsgemäßen FM-Funkempfänger.

### Beschreibung der Erfindung

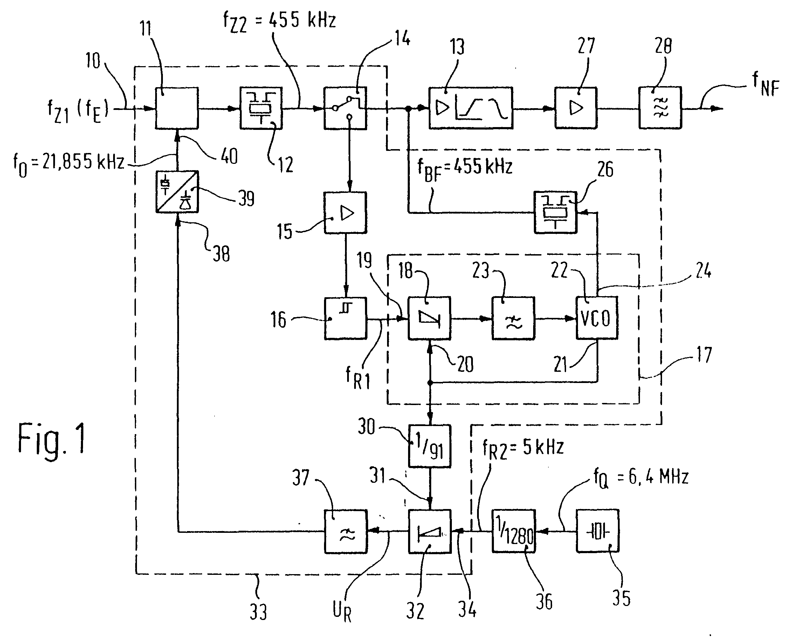

In dem in Fig. 1 dargestellten Blockschaltbild einer FM-Funkempfängerschaltung bezeichnet 10 einen Eingang, dem eine Empfangsfrequenz $f_E$ oder eine von der Empfangsfrequenz abgeleitete erste Zwischenfrequenz $f_{Z1}$ zugeführt wird. Im folgenden wird davon ausgegangen, daß die Frequenz am Eingang 10 eine erste Zwischenfrequenz $f_{Z1}$ ist. An den Eingang 10 schließt sich eine Mischstufe 11 an, auf die ein Zwischenfrequenzbandfilter 12, das ist vorzugsweise ein auf eine zweite Zwischenfrequenz $f_{Z2}$ von zum Beispiel 455 kHz abgestimmtes keramisches Filter mit einer verhältnismäßig großen Bandbreite von zum Beispiel 14 kHz, folgt, Zwischen dem Zwischenfrequenzbandfilter 12 und einem Zwischenfrequenzbaustein 13, der einen Zwischenfrequenzverstärker, einen Zwischenfrequenzbegrenzer und einen Demodulator umfaßt, liegt ein von Hand zu betätigender Umschalter 14, der in der einen Schaltstellung das Zwischenfrequenzbandfilter 12 mit dem Zwischenfrequenzbaustein 13 und in der anderen Schaltstellung das Zwischenfrequenzbandfilter 12 über einen Verstärker 15 und einen Schwellwertschalter 16, das ist vorzugsweise ein Schmitt-Trigger, mit einer ersten PLL (Phase-locked loop)-Schleife 17 verbindet. Die erste PLL-Schleife weist einen Phasendetektor 18 auf, dessen erster Eingang 19 (Referenzfrequenzeingang) mit dem Schwellwertschalter und dessen zweiter Eingang 20 mit einem ersten Ausgang 21 eines ersten spannungsgesteuerten Oszillators 22 verbunden ist. Ein Ausgang des Phasendetektors 18 steht über ein Tiefpaßfilter 23 mit dem Eingang des spannungsgesteuerten Oszillators 22 in Verbindung. Ein zweiter Ausgang 24 des spannungsgesteuerten Oszillators 22 ist über ein Bandfilter 26, das ist vorzugsweise ein auf eine Frequenz $f_{BF}$ von 455 kHz abgestimmtes und eine verhältnismäßig kleine Bandbreite von zum Beispiel nur 4 kHz aufweisendes Keramikfilter, mit dem Eingang des Zwischen-frequenzbausteins 13 verbunden, auf den ein NF-Vorverstärker 27 und ein NF-Bandpaßfilter 28 folgen.

Der erste spannungsgesteuerte Oszillator 22 der ersten PLL-Schleife 17 ist über einen ersten Frequenzteiler 30 mit einem ersten Eingang 31 eines Phasendetektors 32 verbunden, der zu einer zweiten PLL-Schleife 33 gehört, die die erste PLL-Schleife 17 umfaßt. An einem zweiten Eingang 34 des Phasendetektors 32 liegt eine Referenzfrequenz $f_{R2}$ von zum Beispiel 5 kHz, die von einer Frequenz $f_Q$ von zum Beispiel 6,4 MHz eines quarzstabilisierten Oszillators 35 mittels eines zweiten Frequenzteilers 36, der zum Beispiel ein Teilungsverhältnis von 1 : 1280 aufweist, abgeleitet wird. Ein Ausgang des Phasendetektors 32 steht über ein Tiefpaßfilter 37 mit einem Regelspannungseingang 38 eines spannungsgesteuerten Oszillators 39 in Verbindung, dessen Oszillator frequenz $f_0$ von zum Beispiel 21,855 kHz einem Oszillatorfrequenzeingang 40 der Mischstufe 11 zugeführt wird.

Die Wirkungsweise der vorstehend beschriebenen Schaltung ist folgende.

Aus der ersten Zwischenfrequenz $f_{Z1}$ bildet der Mischer 11 in Verbindung mit dem spannungsgesteuerten Oszillator 39 die zweite Zwischenfrequenz $f_{Z2}$, die bei der in Fig. 1 ersichtlichen Schaltstellung des Umschalters 14 in der üblichen Weise in dem Zwischenfrequenzbaustein 13 verstärkt, begrenzt und demoduliert wird. Das durch die Demodulation erhaltene Niederfrequenzsignal wird in dem Niederfrequenzverstärker 27 verstärkt und mittels des Niederfrequenz-Bandpaßfilters 28 selektiert. Auf das Bandpaßfilter folgen dann in bekannter Weise ein Niederfrequenz-Endverstärker und ein Lautsprecher. In der vorstehend beschriebenen Schaltstellung des Umschalters 14 weist der FM-Funkempfänger eine normale Empfindlichkeit auf, die bei einer ausreichenden Empfangsfeldstärke zu einer befriedigenden Empfangsqualität führt.

Wird der Umschalter 14 bei einer nur geringen Empfangsfeldstärke in seine zweite Schaltstellung umgeschaltet, so wird die unmittelbare Verbindung zwischen dem Zwischenfrequenzbandfilter 12 und dem Zwischenfrequenzbaustein 13 unterbrochen. Die zweite Zwischenfrequenz $f_{Z2}$ wird über den Umschalter 14 nach einer Verstärkung mit dem Verstärker 15 dem Schwellwertschalter 16 zugeführt, der aus dem etwa sinusförmigen Zwischenfrequenzsignal der Frequenz $f_{Z2}$ ein rechteckförmiges Signal bildet, das als Referenzsignal mit der Referenzfrequenz $f_{R1}$ dem ersten Eingang 19 des Phasendetektors 18 der ersten PLL-Schleife 17 zugeführt wird. Die erste PLL-Schleife sorgt dafür, daß der spannungsgesteuerte Oszillator 22 an seinen Ausgängen 21 und 24 eine Oszillatorfrequenz abgibt, die mit der ersten Referenzfrequenz $f_{R1}$ fest gekoppelt ist. Dabei bewirkt die erste PLL-Schleife, daß die von dem spannungsgesteuerten Oszillator 22 abgegebene Oszillatorfrequenz mit dem Niederfrequenzsignal moduliert wird. Die modulierte Oszillatorfrequenz $f_{R1}$ wird dem schmalbandigen Bandfilter 26 zugeführt. Das in der Bandbreite begrenzte Signal gelangt dann an den Eingang des Zwischenfrequenzbausteins 13. Die Oszillatorfrequenz des spannungsgesteuerten Oszillators 22 wird gleichzeitig über den ersten Frequenzteiler 30 dem ersten Eingang 31 des Phasendetektors 32 der zweiten PLL-Schleife 33 zugeführt. Die zweite PLL-Schleife soll bewirken, daß das Zwischenfrequenzsignal der Frequenz $f_{Z2}$ in die Bandmitte des schmalbandigen Bandfilters 26 gezogen wird. Der zweite Phasendetektor 32 vergleicht die geteilte Oszillatorfrequenz des spannungsgesteuerten Oszillators 22 mit der quarzstabilen zweiten Referenzfrequenz $f_{R2}$. Die von dem zweiten Phasendetektor 32 abgegebene Regelsignalspannung $U_R$ wird über das Tiefpaßfilter 37 dem spannungsgesteuerten Oszillator 39 zugeführt, das ist vorzugsweise ein durch eine Kapazitätsdiode steuerbarer Quarzoszillator, der die Oszillatorfrequenz $f_0$ liefert. Die zweite PLL-Schleife 33 hält die Zwischenfrequenz $f_{Z2}$ auf dem Wert 455 kHz und somit die dem Bandfilter 26 zugeführte Signalfrequenz auf der Bandmitte dieses Bandfilters.

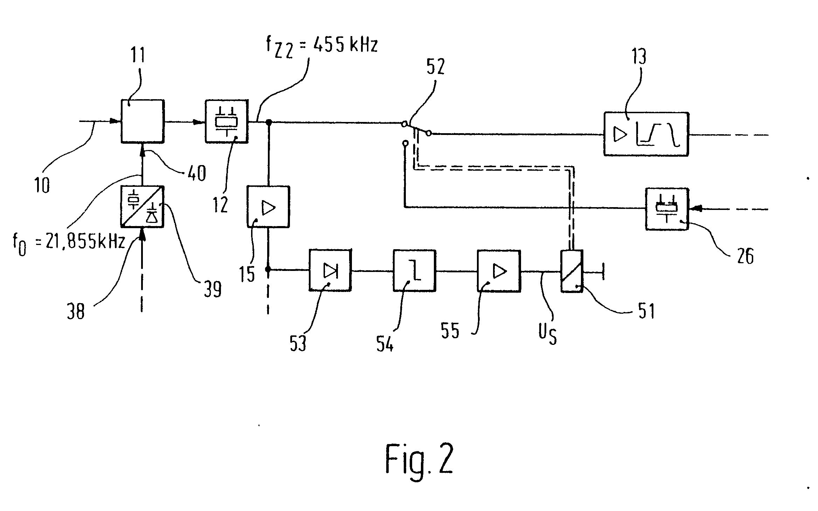

Anstelle des in der Fig. 1 gezeigten, von Hand zu betätigenden Umschalters 14 kann vorteilhafterweise ein automatischer Umschalter treten zu dem eine Wicklung 51 und ein Umschaltkontakt 52 gehören. Die Wicklung 51 wird durch eine Schaltspannung $U_S$ gesteuert, die von der Ausgangsspannung des Verstärkers 15 über eine Reihenschaltung aus einem Gleichrichter 53, einem Schwellwertschalter 54 und einem Schaltspannungsverstärker 55 abgeleitet wird. Solange die am Eingang des Schwellwertschalters 54 liegende Spannung einen bestimmten Wert überschreitet, nimmt der Umschalter die in Fig. 2 gezeigte Schaltstellung ein, in welcher das Zwischenfrequenzbandfilter 12 unmittelbar mit dem Eingang des Zwischenfrequenzbausteins 13 verbunden ist. Hat die Spannung am Eingang des Schwellwertschalters 54 dagegen einen kleineren Wert, dann schaltet das die Wicklung 51 und den Umschaltkontakt 52 aufweisende Relais den Umschaltkontakt in eine zweite Schaltstellung, in welcher das Bandfilter 26 mit dem Zwischenfrequenzbandfilter 12 verbunden wird.

**Patentansprüche**

1. FM-Funkempfänger mit einer Misch- und Oszillatorschaltung zur Bildung einer Zwischenfrequenz, einem Zwischenfrequenzbandfilter (12), einem Zwischenfrequenzverstärker (13), einem Demodulator (13) zum Demodulieren der Zwischenfrequenz und einer ersten (17) und zweiten PLL-Schleife (33), wobei ein spannungsgesteuerter Oszillator (38) der zweiten PLL-Schleife den Oszillator der Misch- und Oszillatorschaltung bildet, dadurch gekennzeichnet, daß die erste PLL-Schleife (17) zwischen dem Zwischenfrequenzbandfilter (12) und dem Zwischenfrequenzverstärker (13) in Serie mit einem zweiten, im Vergleich zu dem ersten Zwischenfrequenzsignal schmalbandigen Bandfilter (26) liegt, wobei die zur Verringerung des Rauschanteils des Zwischenfrequenzsignals beitragende erste PLL-Schleife ihr Ausgangssignal an einen ersten Eingang (31) eines zu der zweiten PLL-Schleife (33) gehörenden Phasendetektors (32) abgibt, an dessen zweiten Eingang (34) ein Referenzfrequenzsignal liegt, und daß die zweite PLL-Schleife die Zwischenfrequenz auf die Bandmitte des Schmalbandigen Bandfilters nachregelt.

2. FM-Funkempfänger nach Anspruch 1, dadurch gekennzeichnet, daß zwischen dem Zwischenfrequenzbandfilter (12) und der ersten PLL-Schleife (17) ein Umschalter (14) liegt, der in einer ersten Schaltstellung das Zwischenfrequenzbandfilter unmittelbar mit dem Zwischenfrequenzverstärker und in einer zweiten Schaltstellung das Zwischenfrequenzbandfilter über einen Verstärker (15), einen Schwellwertschalter (16), die erste PLL-Schleife (17) und das schmalbandige Bandfilter (26) mit dem Zwischenfrequenzverstärker verbindet.

3. FM-Funkempfänger nach Anspruch 1 oder 2, dadurch gekennzeichnet, daß an dem Referenzfrequenzeingang (34) des Phasendetektors (32) der zweiten PLL-Schleife (33) eine quarzstabilsierte Referenzfrequenz ($f_{R2}$) liegt.

4. FM-Funkempfänger nach Anspruch 1 oder 2, dadurch gekennzeichnet, daß die Bandfilter (12, 26) keramische Filter sind.

5. FM-Funkempfänger nach Anspruch 1, dadurch gekennzeichnet, daß der zu dem Mischer (11) gehörende spannungsgesteuerte Oszillator (39) ein Quarzoszillator ist.

6. FM-Funkempfänger nach Anspruch 1, dadurch gekennzeichnet, daß der Umschalter ein in Abhängigkeit von dem Pegel des Zwischenfrequenzsignals gesteuerter Umschalter (51, 52) ist.

## Claims

1. An FM radio receiver having a mixing- and oscillator circuit for forming an intermediate frequency, an intermediate frequency band-pass filter (12), an intermediate frequency amplifier (13), a demodulator (13) for demodulating the intermediate frequency and a first (17) and second phase-locked loop (33), wherein a voltage-controlled oscillator (38) of the second phase-locked loop forms the oscillator of the mixing- and oscillator circuit, characterised in that the first phase-locked loop (17) between the intermediate frequency band-pass filter (12) and the intermediate frequency amplifier (13) is connected in series with a second band-pass filter (26) which is a narrow band filter compared with the first intermediate frequency signal, wherein the first phase-locked loop contributing to the reduction of the noise level of the intermediate frequency signal supplies its output signal to a first input (31) of a phase detector (32) which forms part of the second phase-locked loop (33) and the second input (34) of which carries a reference frequency signal, and that the second phase-locked loop readjusts the intermediate frequency to the mid-band of the narrow band filter.

2. An FM radio receiver as claimed in claim 1, characterised in that a change -over switch (14) is located between the intermediate frequency band-pass filter (12) and the first phase-locked loop (17) and, when in a first switching position, connects the intermediate frequency band-pass filter directly to the intermediate frequency amplifier and, when in a second switching position, connects the intermediate frequency band-pass filter to the intermediate frequency amplifier by way of an amplifier (15), a threshold value switch (16), the first phase-locked loop (17) and the narrow band filter (26).

3. An FM radio receiver as claimed in claim 1 or 2, characterised in that a quartz-stabilized reference frequency ($f_{R2}$) is applied to the reference frequency input (34) of the phase detector (32) of the second phase-locked loop (33).

4. An FM radio receiver as claimed in claim 1 or 2, characterised in that the band-pass filters (12, 16) are ceramic filters.

5. An FM radio receiver as claimed in claim 1, characterised in that the voltage-controlled oscillator (39) forming part of the mixer (11) is a quartz oscillator.

6. An FM radio receiver as claimed in claim 1, characterised in that the change-over switch is a change-over switch (51, 52) controlled in dependence upon the level of the intermediate frequency signal.

## Revendications

1. Récepteur-radio à modulation de fréquence avec un circuit mélangeur et oscillateur pour engendrer une fréquence intermédiaire, avec un filtre passe-bande de fréquence intermédiaire (12), avec un amplificateur de fréquence intermédiaire (13), avec un démodulateur (13) pour démoduler la fréquence intermédiaire et avec une première boucle PLL (17) et une seconde boucle PLL (33), un oscillateur commandé en tension (39) de la seconde boucle PLL constituant l'oscillateur du circuit mélangeur et oscillateur, récepteur caractérisé en ce que la première boucle PLL (17), montée en série avec un second filtre passe-bande (26) de largeur de bande étroite par comparaison avec le premier signal de fréquence intermédiaire, est placée entre le filtre passe-bande de fréquence intermédiaire (12) et l'amplificateur de fréquence intermédiaire (13), tandis que la première boucle PLL, contribuant à réduire le niveau de bruit du signal de fréquence intermédiaire, délivre son signal de sortie à une première entrée (31) d'un détecteur de phases (32) faisant partie de la deuxième boucle PLL (33), et à la seconde entrée (34) duquel s'applique un signal de fréquence de référence, et la seconde boucle PLL réglant la fréquence intermédiaire sur le milieu de la bande du filtre passe-bande à bande étroite.

2. Récepteur radio à modulation de fréquence, selon la revendication 1, caractérisé en ce qu'entre le filtre passe-bande de fréquences intermédiaire (12) et la première boucle PLL (17) est placé un inverseur (14) qui, dans une première position de commutation relie directement le filtre passe-bande de fréquences intermédiaires à l'amplificateur de fréquences intermédiaires, tandis que dans une deuxième position de commutation, il relie le filtre passe-bande de fréquences intermédiaires avec l'amplificateur de fréquences intermédiaires en passant par un amplificateur (15), un commutateur à valeur de seuil (16), la première boucle PLL (17) et le filtre passe-bande à bande étroite (26).

3. Récepteur radio à modulation de fréquence selon la revendication 1 ou 2, caractérisé en ce qu'à l'entrée de fréquences de référence (34) du détecteur de phases (32) de la seconde boucle PLL (33) est appliquée une fréquence de référence ($f_{R2}$) stabilisée par un quartz.

4. Récepteur radio à modulation de fréquence selon la revendication 1 ou 2, caractérisé en ce que les filtres passes-bandes (12, 26) sont des filtres céramiques.

5. Récepteur radio à modulation de fréquence selon la revendication 1, caractérisé en ce que l'oscillateur commandé en tension (39), faisant partie du mélangeur (11), est un oscillateur à quartz.

6. Récepteur radio à modulation de fréquence selon la revendication 1, caractérisé en ce que l'inverseur est un inverseur (51, 52) commandé en fonction du niveau du signal de fréquence intermédiaire.

Fig. 1

Fig. 2